# EUROPÄISCHE PATENTSCHRIFT

(11) **EP 0 544 995 B1**
(45) Veröffentlichungstag und Bekanntmachung des Hinweises auf die Patenterteilung: **11.10.1995**
(21) Anmeldenummer: 92113182.7
(22) Anmeldetag: 03.08.1992
(51) Int. Cl.: B65G 49/07

(54) **Vorrichtung für den Transport von Substraten**
Apparatus for transporting substrates
Dispositif pour le transport de substrats

(30) Priorität: 30.11.1991 DE 4139549
(43) Veröffentlichungstag der Anmeldung: 09.06.1993
(73) Patentinhaber: LEYBOLD AKTIENGESELLSCHAFT, 63450 Hanau (DE)
(72) Erfinder: Mahler, Peter, W-6452 Hainburg - 2 (DE); Wolf, Hans, W-6455 Erlensee (DE)

(56) Entgegenhaltungen:
- DD-A- 285 514
- DE-A- 4 036 339

## Beschreibung

Die Erfindung betrifft eine Vorrichtung für den Transport von Substraten in und durch Vakuum-Behandlungsanlagen mit mehreren Stationen sowie einer Heizeinrichtung, mit Substrathaltern etwa plattenförmiger, flacher, parallelepipeder Konfiguration, die in lotrechter Stellung - entlang eines vorgegebenen Transportweges - durch die Stationen bewegbar sind.

Die zum Einsatz kommenden Substrathalter sind entweder Platten mit entsprechend den Substraten geformten Ausschnitten oder Rahmen mit Streben, an denen die Substrate befestigt werden. Im allgemeinen dient ein Substrathalter zur Aufnahme einer Vielzahl von Substraten, die meist eine flache und plattenförmige Form aufweisen.

Durch die US-A-4,042,128 ist eine Transporteinrichtung bekannt, bei der plattenförmige Substrathalter bei vertikaler Lage ihrer Hauptebene an ihren oberen und unteren Längskanten zwischen Rollen geführt werden, die um senkrechte Achse drehbar sind. An ihren Unterkanten liegen die Substrathalter zusätzlich auf Stützrollen mit horizontaler Drehachse auf.

Bekannt ist auch eine Transporteinrichtung für Vakuum-Beschichtungsanlagen (EP-B-0 254 145) mit mehreren Stationen und mit Rollensystemen für die Führung und den Vorschub von im wesentlichen zweidimensionalen Substrathaltern in senkrechter Stellung entlang eines vorgegebenen Transportweges durch die Stationen, wobei im Bereich der Unterkante der Substrathalter paarweise Führungsrollen angeordnet sind, die den Substrathalter zwischen sich aufnehmen und die um senkrechte Achse drehbar sind.

Diesen bekannten Transporteinrichtungen lag die Aufgabe zugrunde, die Störung des Beschichtungsvorganges durch herabrieselndes Schichtmaterial soweit wie möglich auszuschließen.

Weiterhin hat man bereits vorgeschlagen, den Substrathalter bei einer Transporteinrichtung für eine Vakuum-Beschichtungsanlage mit einem Fußteil auszustatten, das auf ortsfesten Schienen gleitet (EP-A-0 346 815).

In einer älteren Patentanmeldung (DE-A-40 29 905) für eine Vorrichtung zum Transport von Substraten bei Vakuum-Behandlungsanlagen mit mehreren Stationen ist vorgeschlagen worden, jedes Fußteil mit einem Paar parallel und im Abstand zueinander verlaufender, in einer lotrechten Ebene angeordneten Substrathalter zu versehen. In die dabei zwischen den Substrathaltern entstandene schachtförmige Ausspannung ragt ein Heizkörper hinein, der sich von dem oberen Wandteil der Vakuumkammer lotrecht nach unten zu erstreckt.

Nachteilig bei den bekannten Vorrichtung ist, daß sich durch die erforderliche Substrattemperatur von ca. 450 °C ein Temperatureinfluß auf den Substrathalter nicht vermeiden läßt und diese Temperatureinwirkung Wärmespannungen und Verzug der gesamten Vorrichtung bedingt. Aufgrund der engen maßlichen Toleranzen der Substrate und der Rollenführungen der Substrate haben die durch Wärmeeinfluß bedingten Maßänderungen aller Bauteile einen erheblichen Einfluß auf die Betriebssicherheit und Zuverlässigkeit der Anlagen und führen damit zu Betriebsstörungen der meist vollautomatisch betriebenen Anlagen, die eine Unterbrechung des Behandlungsbetriebes erforderlich machen und somit erhebliche Kosten verursachen.

Es hat sich weiterhin als nachteilig erwiesen, daß, wenn ein Substrathalter aus der Beschichtungszone herausgefahren und ein weiterer hineingefahren wird, die in dem Zwischenraum des Substrathalters ortsfest installierte Heizung mit beschichtet wird. Dies führt mit zunehmender Betriebsdauer zu einer Leistungseinbuße des Heizkörpers.

Hauptaufgabe der vorliegenden Erfindung ist es nun, eine Vorrichtung zu entwickeln, die unempfindlich gegen Temperatureinfluß ist und einen stabilen, störungsfreien Betrieb der Anlage bei hohen Temperaturen gewährleistet. Weiterhin wäre es wünschenswert ein Beschichten der Heizung zu vermeiden und somit möglichst lange Wartungsintervalle zu erreichen.

Diese Aufgabe wird durch die Merkmale des Anspruchs 1 gelöst.

Die konsequente und filigrane Rahmenbauweise mit geringer Masse, sowohl des gesamten Kopfteils als auch des Substrathalters und die bewegliche Ausführung der Halterung der Bauteile untereinander, macht die Vorrichtung weitgehend unempfindlich gegen Temperatureinfluß und maßlichen Verzug.

Durch die Anbringung seitlicher Abschirmbleche an den senkrechten Stützen der Substrat-Traggestelle wird vorteilhafterweise auch eine Beschichtung der Substrat-Heizung vermieden.

Weitere Ausführungsmöglichkeiten und Merkmale sind in den Unteransprüchen näher beschrieben und gekennzeichnet.

Die Erfindung läßt die verschiedensten Ausführungsmöglichkeiten zu; eine davon ist beispielhaft in den anhängenden Zeichnungen näher dargestellt, und zwar zeigen:
- Figur 1: einen Substrathalter mit eingesetzten Substraten zwischen zwei gegenüberliegenden Zerstäubungsquellen in Schnittdarstellung,
- Figur 2: einen Substrathalter nach Figur 1 in der Seitenansicht,
- Figur 3: einen Substrathalter in einer Schnittdarstellung entlang der Linie X-X in Figur 2, und
- Figur 4: einen Substrathalter mit einer Rad-/Schiene-Einrichtung in Schnittdarstellung.

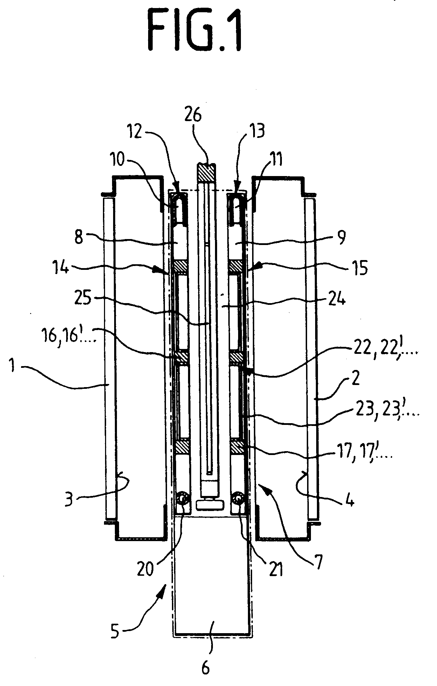

In einer Beschichtungskammer, die der Einfachheit halber nicht dargestellt ist, sind zwei Zerstäubungsquellen 1, 2 so angeordnet (Figur 1), daß sich ihre Wirkflächen 3, 4 bei gleichbleibendem Abstand gegenüberliegen. Zwischen den beiden Zerstäubungsquellen 1, 2 befindet sich ein Tragrahmen 5, der aus einem massiven Fußteil 6 sowie einem stabwerkähnlichen Kopfteil 7 besteht. In dem Fußteil 6 ist beispielsweise eine nicht dargestellte Vorrichtung zum Halten und Führen des Tragrahmens in der Beschichtungskammer vorgesehen. Das Kopfteil 7 setzt sich zusammen aus je zwei senkrechten Stützen 8, 9, die an den gegenüberliegenden Enden des Fußteils 6 befestigt sind, und zwei waagrechten Trägern 10, 11, die aus der Zeichenebene herauszeigen und mit den jeweils oberen Enden der senkrechten Stützen 8, 9 verbunden sind.

Diese beiden, durch je zwei senkrechte Stützen 8, 9 und einen waagrechten Träger 10, 11 gebildeten Rahmen sind nicht als geschlossene Rahmen ausgeführt, sondern haben mindestens eine bewegliche Verbindungsstelle zwischen je zwei Bauteilen. Dadurch wird eine Längenänderung durch Wärmeeinfluß ermöglicht, ohne temperaturbedingte Verformungen des Tragrahmens 5 in Kauf nehmen zu müssen.

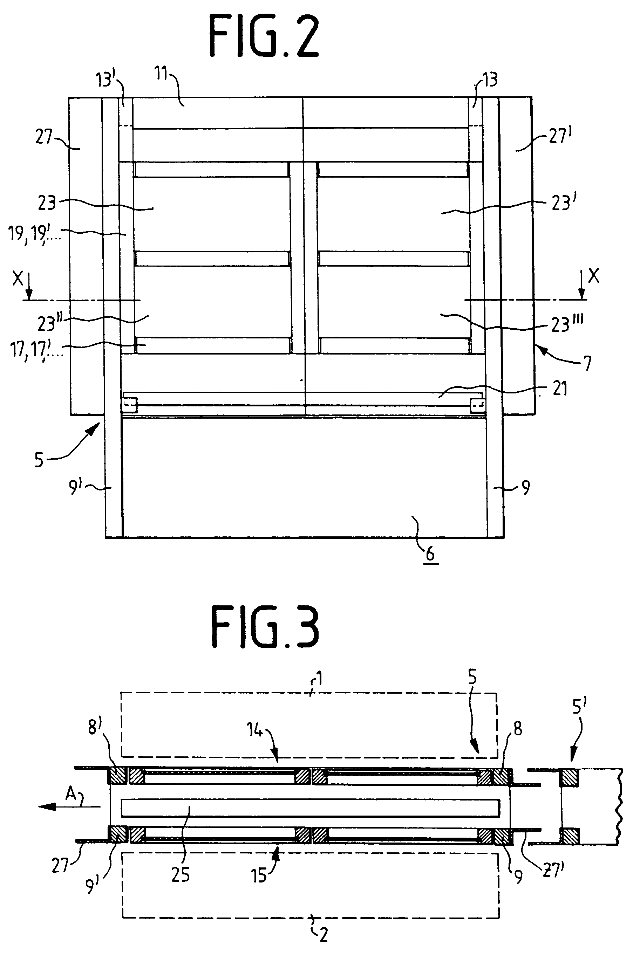

Auf die beiden waagrechten Träger 10, 11 sind mittels zwei U-förmiger Haken 12, 13 die Substrathalter 14, 15 aufgehängt. Diese bestehen aus mehreren waagrechten, parallel zu den Trägern 10, 11 angeordneten Tragholmen 16, 16', ..., 17, 17', ..., sowie aus mehreren senkrechten, parallel zu den Stützen 9, 9' angeordneten Stützen 19, 19', ... (Figur 2). Die Substrathalter 14, 15 stützen sich an ihrem jeweils unteren Ende gegen die in dem Tragrahmen 5 eingesetzten horizontal verlaufenden Tragrohre 20, 21 ab. Die horizontalen Tragholme 16, 16', ..., 17, 17', ... sind mit Schlitzen 22, 22', ... versehen, in die die zu beschichtenden plattenförmigen Substrate 23, 23', ... so eingesetzt sind, daß ihre Vorder- und Rückseiten parallel zu den Wirkflächen 3, 4 der Zerstäubungsquellen 1, 2 verlaufen.

Durch die beiden Substrathalter 14, 15 wird ein nach oben offener Zwischenraum 24 gebildet, in den eine zentrale Heizung 25 eingehängt ist, welche mittels eines Trägers 26 an der Kammerdecke der nicht dargestellten Beschichtungskammer befestigt ist.

In den rechteckförmigen Tragrahmen 5 (Figur 2) sind die im wesentlichen ebenfalls rechteckförmigen Substrate 23, 23', ... schachbrettartig eingesetzt.

An den senkrechten Stützen 9, 9', ... sind seitlich Abschirmbleche 27, 27', ... vorgesehen, welche so angeordnet sind, daß sich die Abschirmbleche zweier benachbarter Tragrahmen 5, 5', ... überlappen (Figur 3). Dadurch wird die Beschichtung, der zwischen zwei Substrathaltern 14, 15 befindlichen Heizung 25 vermieden, wenn die Tragrahmen 5, 5' in Richtung A an den ortsfesten Zerstäubungsquellen 1, 2 vorbeibewegt werden.

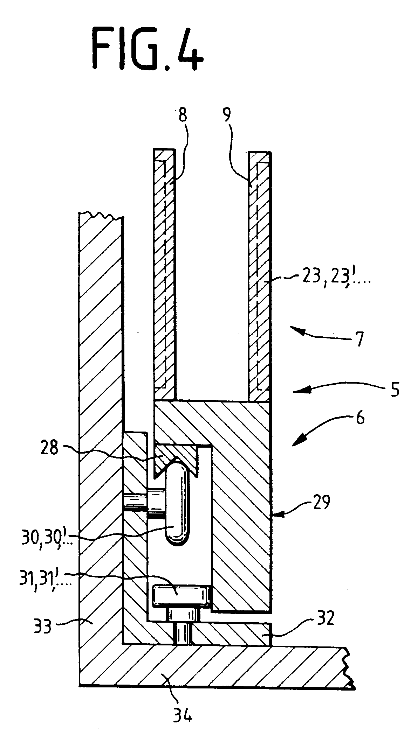

Der Tragrahmen 5 zur Aufnahme der Substrate 23, 23', ... besteht im wesentlichen aus einem Fußteil 6 und einem Kopfteil 7 (Figur 4). Zum Halten und Führen des Rahmens 5 in der Vakuumkammer ist in dem Fußteil 6 die Schiene 28 vorgesehen, welche auf einer Reihe von Rädern 30, 30', ... aufliegt. Ein vertikaler Schenkel 29 des Fußteils 6 stützt sich an einer zweiten Reihe von Rädern 31, 31', ... ab. Diese Radsätze 30, 30', ..., 31, 31', ... sind in einem sich horizontal erstreckenden L-förmigen Gehäuserahmen 32 befestigt, der wiederum an der Wand 33 und dem Boden 34 der Vakuumkammer montiert ist.

## Patentansprüche

1. Vorrichtung für den Transport von Substraten (23, 23', ...) in und durch Vakuum-Behandlungsanlagen mit mehreren Stationen sowie einer Heizeinrichtung, mit Substrathaltern etwa plattenförmiger, flacher, parallelepipeder Konfiguration, die in lotrechter Stellung entlang eines vorgegebenen Transportweges durch die Stationen bewegbar sind, wobei ein massives Fußteil (6) mit Einrichtungen zum Halten und Führen in einer Vakuumkammer vorgesehen ist, beispielsweise bestehend aus zwei Radsätzen (30, 30', ..., 31, 31', ...), die mit einer Schiene (28) und einem Stützlager (29) korrelieren und auf diesem Fußteil (6) ein Kopfteil (7) vorgesehen ist, das als filigraner, ebener Rahmen ausgebildet ist, an dem die zu behandelnden Substrate (23, 23', ...) mittels eines Substrathalters (14, 15) gehalten sind, und diese Halterung des Substrathalters (14, 15) an dem Rahmen beweglich ausgeführt ist und eine Relativbewegung zwischen Substrathalter (14, 15) und Rahmen, beispielsweise eine Längenänderung durch Erwärmung ermöglicht.

2. Vorrichtung nach Anspruch 1, **dadurch gekennzeichnet**, daß das Fußteil (6) einstückig und im wesentlichen von parallelepipeder Gestalt ausgeführt ist.

3. Vorrichtung nach Anspruch 1 oder 2, **dadurch gekennzeichnet**, daß das Fußteil (6) mittels einer Rad/Schiene Einrichtung gehalten und geführt ist.

4. Vorrichtung nach Anspruch 1, **dadurch gekennzeichnet**, daß das Kopfteil (7) mit dem Fußteil (6) fest verbunden ist.

5. Vorrichtung nach Anspruch 4, **dadurch gekennzeichnet**, daß das Kopfteil (7) aus mehreren senkrechten Stützen (8, 8', 9, 9') und waagrechten Trägern (10, 11) besteht.

6. Vorrichtung nach Anspruch 4 oder 5, **dadurch gekennzeichnet**, daß die Stützen (8, 8', 9, 9') und Träger (10, 11) eines Rahmens an mindestens einer Verbindungsstelle beweglich zueinander ausgeführt sind und eine Relativbewegung zueinander, beispielsweise eine Längenänderung durch Erwärmung, ermöglichen.

7. Vorrichtung nach Anspruch 1, **dadurch gekennzeichnet**, daß der Substrathalter (14, 15) mittels unten offener Haken (12, 12', 13, 13'), die am oberen Ende der Substrathalter (14, 15) vorgesehen sind, auf den Trägern (10, 11) des Rahmens gehalten ist.

8. Vorrichtung nach Anspruch 1**, dadurch gekennzeichnet**, daß je zwei baugleiche Substrathalter (14, 15) spiegelsymmetrisch zueinander angeordnet sind.

9. Vorrichtung nach Anspruch 8, **dadurch gekennzeichnet**, daß zwischen zwei, auf einem Fußteil (6), befindlichen Substrathaltern (14, 15) ein schmaler, hoher, parallelepipeder, nach oben offener Zwischenraum (24) vorgesehen ist.

10. Vorrichtung nach Anspruch 9, **dadurch gekennzeichnet**, daß in den Zwischenraum (24) eine an der Decke der Vakuumkammer gehaltene Heizung (25) von oben hineinragt.

11. Vorrichtung nach Anspruch 5, **dadurch gekennzeichnet**, daß an den Außenseiten der senkrechten Stützen (8, 8', 9, 9') des Kopfteils (7) Abschirmbleche (27, 27', ...) vorgesehen sind, wobei diese in der Haupterstreckungsrichtung der Substrate (23, 23', ...) verlaufen.

12. Vorrichtung nach Anspruch 11, **dadurch gekennzeichnet**, daß sich die Abschirmbleche (27, 27', ...) zweier benachbarter Traggestelle (5, 5') lückenlos überlappen.

## Claims

1. Apparatus for conveying substrates (23, 23', ...) in and through vacuum treatment installations having a plurality of stations and a heating arrangement, with substrate holders which are in an approximately plate-shaped, flat, parallelepipedal configuration and which are movable in the vertical position, along a predetermined conveying path through the stations, a solid base part (6) being provided with arrangements for holding and guiding in a vacuum chamber, for example comprising two wheelsets (30, 30', ..., 31, 31', ...) which are associated with a rail (28) and a support bearing (29), and this base part (6) being provided with a head part (7) which is in the form of a filigrained, flat frame on which the substrates (23, 23', ...) to be treated are held by means of a substrate holder (14, 15), and this system for holding the substrate holder (14, 15) on the frame being constructed so as to be movable and rendering possible a relative movement between the substrate holder (14, 15) and the frame, for example a variation in length caused by heating.

2. Apparatus according to Claim 1, characterized in that the base part (6) is in one piece and is substantially parallelepipedal.

3. Apparatus according to Claim 1 or 2, characterized in that the base part (6) is held and guided by a wheel/rail arrangement.

4. Apparatus according to Claim 1, characterized in that the head part (7) is rigidly connected to the base part (6).

5. Apparatus according to Claim 4, characterized in that the head part (7) comprises a plurality of vertical supports (8, 8', 9, 9') and horizontal carriers (10, 11).

6. Apparatus according to Claim 4 or 5, characterized in that the supports (8, 8', 9, 9') and carriers (10, 11) of a frame are constructed so as to be movable relative to one another at one connection point at least and render possible a relative movement with respect to one another, for example a variation in length caused by heating.

7. Apparatus according to Claim 1, characterized in that the substrate holder (14, 15) is held on the carriers (10, 11) by means of hooks (12, 12', 13, 13') which are open at the bottom and which are provided at the upper end of the substrate holders (14, 15).

8. Apparatus according to Claim 1, characterized in that two structurally identical substrate holders (14, 15) are arranged in a mirror-symmetrical manner relative to one another in each case.

9. Apparatus according to Claim 8, characterized in that a narrow, high, parallelepipedal intermediate space (24) which is open at the top is provided between two substrate holders (14, 15) located on a base part (6).

10. Apparatus according to Claim 9, characterized in that a heating system (25) mounted on the vacuum chamber ceiling projects from above into the intermediate space (24).

11. Apparatus according to Claim 5, characterized in that shield plates (27, 27', ...) are provided on the outer sides of the vertical supports (8, 8', 9, 9') of the head part (7) and extend in the direction of the principal extension of the substrates (23, 23', ...).

12. Apparatus according to Claim 11, characterized in that the shield plates (27, 27', ...) of two adjacent carrier frames (5, 5') overlap without a gap.

## Revendications

1. Dispositif de transport de substrats (23, 23', ...) dans et à travers des installations de traitement sous vide, comportant plusieurs stations ainsi qu'un dispositif de chauffage, des porte-substrats de configuration approximativement parallélépipédique, plate et en forme de plaque, qui peuvent être déplacés à travers les stations en position verticale, le long d'une voie de transport prédéterminée ; dans lequel un pied (6) massif comportant un dispositif de maintien et de guidage est prévu dans une chambre à vide, ce dispositif étant par exemple constitué par deux jeux de roues (30, 30', ..., 31, 31', ...) qui sont en corrélation avec un rail (28) et avec un appui (29) ; sur ce pied (6) est prévu une tête (7) , sous forme d'un cadre plan en filigrane sur lequel les substrats (23, 23', ...) à traiter sont maintenus au moyen d'un porte-substrats (14, 15) ; et ce maintien du porte-substrats (14, 15) est réalisé mobile sur le cadre, et permet un mouvement relatif entre le porte-substrats (14, 15) et le cadre, par exemple une variation de longueur par réchauffement.

2. Dispositif selon la revendication 1, caractérisé en ce que le pied (6) est réalisé d'une seule pièce et de forme sensiblement parallélépipédique.

3. Dispositif selon l'une ou l'autre des revendications 1 et 2, caractérisé en ce que le pied (6) est maintenu et guidé au moyen d'un dispositif de roue/rail.

4. Dispositif selon la revendication 1, caractérisé en ce que la tête (7) est reliée de manière solidaire au pied (6).

5. Dispositif selon la revendication 4, caractérisé en ce que la tête (7) est constituée par plusieurs montants verticaux (8, 8', 9, 9') et par des supports (10, 11) horizontaux.

6. Dispositif selon l'une ou l'autre des revendications 4 et 5, caractérisé en ce que les montants (8, 8', 9, 9') et les supports (10, 11) d'un cadre sont réalisés mobiles les uns par rapport aux autres au moins en un point de liaison et permettent un mouvement relatif les uns par rapport aux autres, par exemple une variation de longueur par réchauffement.

7. Dispositif selon la revendication 1, caractérisé en ce que le porte-substrats (14, 15) est maintenu sur les supports (10, 11) du cadre au moyen de crochets (12, 12', 13, 13') ouverts vers le bas qui sont prévus sur l'extrémité supérieure du porte-substrats (14, 15).

8. Dispositif selon la revendication 1, caractérisé en ce que deux porte-substrats (14, 15) respectifs de même construction sont agencés symétriquement l'un par rapport à l'autre.

9. Dispositif selon la revendication 8, caractérisé en ce qu'un espace intermédiaire (24) étroit, haut, parallélépipédique, ouvert vers le haut est prévu entre deux porte-substrats (14, 15) qui se trouvent sur un pied (6).

10. Dispositif selon la revendication 9, caractérisé en ce qu'un élément de chauffage (25) retenu au plafond de la chambre à vide fait saillie depuis le haut dans l'espace intermédiaire (24).

11. Dispositif selon la revendication 5, caractérisé en ce que sur les faces extérieures des montants verticaux (8, 8', 9, 9') de la tête (7) sont prévues des tôles de blindage (27, 27', ...), celles-ci s'étendant dans la direction d'extension principale des substrats (23, 23', ...).

12. Dispositif selon la revendication 11, caractérisé en ce que les tôles de blindage (27, 27', ...) de deux cadres portants (5, 5') voisins se chevauchent sans intervalle.
